# EUROPEAN PATENT SPECIFICATION

(11) **EP 1 776 002 B1**
(45) Date of publication and mention of the grant of the patent: **23.11.2011**
(21) Application number: 05780155.7
(22) Date of filing: 27.07.2005
(51) Int. Cl.: H05K 1/18, H05K 1/14, H05K 3/28, H01L 25/00

(54) **COMPOSITE ELECTRONIC COMPONENT AND METHOD FOR MANUFACTURING THE SAME**
ELEKTRONISCHES VERBUNDBAUTEIL UND VERFAHREN ZU SEINER HERSTELLUNG
COMPOSANT ÉLECTRONIQUE COMPOSITE ET PROCÉDÉ DE FABRICATION DE CELUI-CI

(30) Priority: 30.07.2004 JP 2004224922; 21.06.2005 JP 2005011358
(43) Date of publication of application: 18.04.2007
(73) Proprietor: MURATA MANUFACTURING CO., LTD., Nagaokakyo-shi, Kyoto 617-8555 (JP)
(72) Inventor: NODA, Satoru, Murata Manufacturing Co., Ltd., Nagaokakyo-shi Kyoto 617-8555 (JP); HARADA, Jun, Murata Manufacturing Co, . Ltd., Nagaokakyo-shi Kyoto 617-8555 (JP)
(74) Representative: Schoppe, Fritz
(86) International application number: PCT/JP2005/013724
(87) International publication number: WO 2006/011508

(56) References cited:
- EP-A- 1 085 788
- EP-A2- 0 642 166
- JP-A- 9 046 046
- JP-A- 2003 188 338
- JP-A- 2003 249 510
- US-A- 5 248 852
- US-A1- 2003 137 045
- US-A1- 2004 104 466

## Description

### Technical Field

The present invention relates to composite electronic components and methods for manufacturing the composite electronic components. More particularly, the present invention relates to a composite electronic component in which a plurality of types of substrates having different characteristics are integrated to provide a desired function and realizing miniaturization and profile reduction, and to a method of manufacturing the composite electronic component.

### Background Art

In recent years, with miniaturization and enhancement of functions of mobile communication devices such as portable phones and electronic devices, miniaturization and enhancement of functions of electronic components have rapidly progressed. For example, in Patent Document 1, a circuit component built-in module having a circuit components built therein and being modularized and a method of manufacturing the circuit component built-in module are proposed.

The circuit component built-in module described in Patent Document 1 includes an electrical insulating substrate formed of a mixture containing an inorganic filler and a thermosetting resin, a plurality of wiring patterns disposed on at least one major surface of the electrical insulating substrate, and a circuit component embedded in the electrical insulating substrate and electrically connected to the wiring patterns. The circuit component and the wiring patterns are electrically connected through conductive adhesive (or bumps). In addition, in Patent Document 1, a circuit component built-in module having a multilayer structure in which a plurality of electrical insulating substrates are laminated is proposed. In Patent Document 1, an inner via connection method is used with a view to increasing the density and enhancing the functions of the circuit component. In addition, a mixture containing an inorganic filler and a thermosetting resin is used as a material for forming the electrical insulating substrate, with a view to increasing reliability.

Patent Document 1: Japanese Patent No. 3375555

### Disclosure of Invention

### Problems to be Solved by the Invention

However, in a conventional composite electronic component, as in the circuit component built-in module described in Patent Document 1, a plurality of wiring patterns ar disposed on at least one major surface of an electrical insulating substrate, and a circuit component connected to these wiring patterns is embedded in the electrical insulating substrate. Thus, when a plurality of different types of circuit components are built into the electrical insulating substrate so that the electrical insulating substrate has various functions,
the heights of the circuit components are limited to the height of the electrical insulating substrate. In addition, since it is difficult to arrange a wiring layer inside the electrical insulating substrate in which the circuit components are embedded, despite the presence of high-density wiring, it is inevitable that the wiring layer has to be provided on the top or bottom of the electrical insulating substrate. Thus, there has been a problem in that it is difficult to reduce the profile of a composite electronic component. US 2003/0137045 discloses a circuit component built-in module. The module includes a first electrical insulating substrate made of a mixture containing an inorganic filler and a thermosetting resin, a plurality of wiring patterns formed at least on a principal surface of the first electrical insulating substrate, a semiconductor chip incorporated in the first electrical insulating substrate and connected electrically with the wiring patterns, and inner vias electrically connecting the plurality of wiring patterns with one another, the inner vias passing through the first electrical insulating substrate.

It is an object of the present invention to provide a composite electronic component in which various substrates and electric components having different functions are combined to provide various functions and to promote miniaturization and profile reduction, and a method of manufacturing the composite electronic component.

This object is achieved by a composite electronic component according to claim 1 and a method of manufacturing a composite electronic component according to claim 4.

According to the invention according to claim 1 to claim 4, there can be provided a composite electronic component in which various substrates and electronic components having different functions are combined, and thus capable of providing various functions and also promoting miniaturization and profile reduction and a method of manufacturing the composite electronic component.

### Brief Description of the Drawings

Fig. 1 shows diagrams (a) and (b) each illustrating an example of a composite electronic component , and (a) is a cross-sectional diagram of the composite electronic component and (b) is a cross-sectional diagram showing an enlarged view of a part of the composite electronic component.
Fig. 2 shows perspective diagrams (a) to (c) each illustrating a manufacturing method of the composite electronic component illustrated in Fig. 1 in the order of steps.
Fig. 3 shows cross-sectional diagrams (a) and (b) in the steps illustrated in Fig. 2, and (a) is a diagram illustrating a state in which a multilayer wiring block etc. are implemented on a supporting substrate and (b) is a diagram illustrating a state in which a resin sheet is press-bonded.
Fig. 4 is a cross-sectional diagram illustrating another example of a composite electronic component.
Fig. 5 is a cross-sectional diagram illustrating further another example of a composite electronic component.
Fig. 6 is a cross-sectional diagram illustrating further another example of a composite electronic component.
Fig. 7 is a cross-sectional diagram illustrating further another example of a composite electronic component.
Fig. 8 is a cross-sectional diagram illustrating further another example of a composite electronic component.
Fig. 9 shows diagrams (a) and (b) each illustrating an embodiment of a composite electronic component of the present invention, and (a) is a perspective diagram illustrating major parts of steps in an embodiment of a manufacturing method of a composite electronic component of the present invention and (b) is a cross-sectional diagram illustrating a composite electronic component created in accordance with the manufacturing method illustrated in (a).
Fig. 10 is a perspective diagram illustrating another embodiment of a composite electronic component of the present invention.
Fig. 11 is a perspective diagram illustrating further another embodiment of a composite electronic component of the present invention,
Fig. 12 is a crass-sectional diagram illustrating further another embodiment of a composite electronic component of the present invention.
Fig. 13 is a crass-sectional diagram illustrating further another embodiment of a composite electronic component of the present invention.
Fig. 14 is a crass-sectional diagram illustrating further another embodiment of a composite electronic component of the present invention.

### Reference Numerals

[21] 10, 10A, 10B, 10C, 10D, 10E, 10F, 10G, 10H, 10I, 10J, 10K composite electronic components
11 multilayer wiring block
11B wiring pattern
12 chip-type electronic component built-in multilayer block
12C wiring pattern
13 second chip-type electronic component
14 supporting substrate
18 chip-type electronic component block
18A thermosetting resin
19, 20, 21, 22 resin block

### Best Mode for Carrying Out the Invention

### First Example

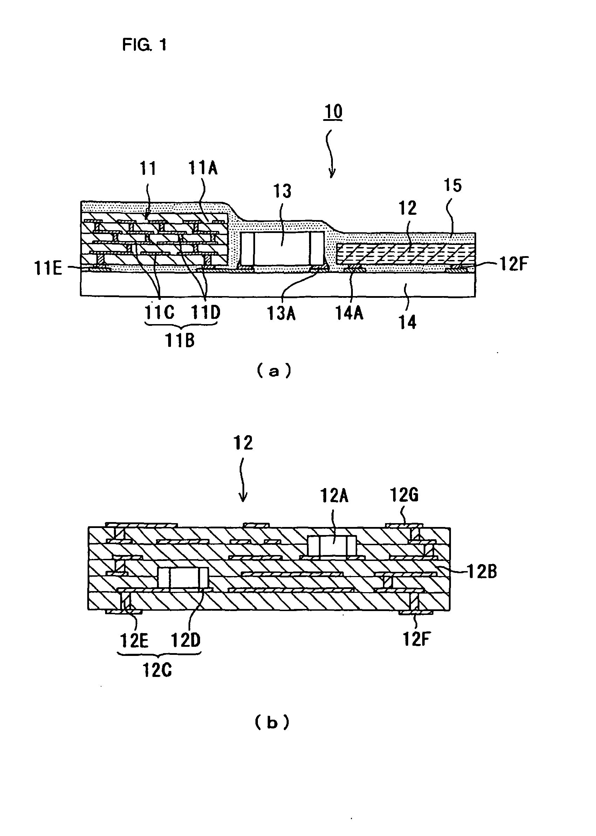

In the following, the present invention will be described on the basis of examples and embodiments illustrated in Fig. 1 to Fig. 14.
As illustrated in (a) and (b) in Fig. 1, for example, a composite electronic component 10 has a multilayer wiring block 11, a chip-type electronic component built-in multilayer block.12 containing a first chip-type electronic component 12A therein, a second chip-type electronic component 13, a supporting substrate 14 having these three parts 11, 12, and 13 implemented thereon and supporting these three parts, and a resin portion 15 sealing the multilayer wiring block 11, the chip-type electronic component built-in multilayer block 12, and the second chip-type electronic component 13 on the supporting substrate 14 so as to integrate these three parts. The multilayer wiring block 11, the chip-type electronic component built-in multilayer block 12, and the second chip-type electronic component 13 are electrically interconnected on the supporting substrate 14 through a surface wiring pattern 14A provided on the surface of the supporting substrate 14.

The multilayer wiring block 11 is made by dividing a wiring portion of the composite electronic component 10 into blocks. Basically, the multilayer wiring block 11 is a block serving as a passive functional part as a wiring pattern. As illustrated in (a) in Fig. 1, for example, this multilayer wiring block 11 has a laminated body composed of a plurality of laminated insulating layers 11A and a wiring pattern 11B disposed inside the laminated body in a predetermined pattern. This wiring pattern 11B is composed of a plurality of inner conducting planes 11C each arranged between the individual insulating layers 11A, and via hole conductors 11D each penetrating the individual insulating layers 11A and electrically connecting upper and lower inner conducting planes 11C. The multilayer wiring block 11 may include a passive element, such as an inductor, capacitor, or the like, connected to appropriate inner conducting planes 11C. The multilayer wiring block 11 is connected to the surface wiring pattern 14A of the supporting substrate 14 through an external terminal electrode 11E disposed on the bottom surface of the multilayer wiring block 11.

The insulating layers 11A can be formed of a thermosetting resin such as an epoxy resin, a phenolic resin, and a cyanate resin, for example. In this case, the multilayer wiring block 11 can be formed using, for example, a build-up method, and the inner conducting planes 11C can be formed by patterning metal foil such as copper foil, for example. The via hole conductors 11D can be formed by filling via holes disposed in the insulating layers 11A with conductive paste. The conductive paste is a conductive resin composition containing, for example, metal particles and a thermosetting resin. For the metal particles, a metal such as gold, silver, copper, and nickel, for example, can be used. For the thermosetting resin, a resin such as an epoxy resin, a phenolic resin, and a cyanate resin, for example, can be used.

In addition, the insulating layers 11A can be formed of a ceramic material having low conductivity. For the ceramic material, a low temperature sintering ceramic material is preferred. For the low temperature sintering ceramic material, ceramic powder such as alumina, forsterite, and cordierite, a glass composite material containing borosilicate glass mixed with such ceramic powder, a crystallized glass material using crystallized glass of the ZnO-MgO-Al₂O₃-SiO₂ system, and a non-glass material using ceramic powder of the BaO-Al₂O₃-SiO₂ system, ceramic powder of the Al₂O₃-CaO-SiO₂-MgO-B₂O₃ system, etc., can be given as examples. In these cases, the inner conducting planes 11C and the via hole conductors 11D can be integrated by co-firing of a metal having a low resistance and a low melting point such as Ag, Cu, etc., with a low temperature sintering ceramic material, at a low temperature.

The chip-type electronic component built-in multilayer block 12, similarly to the multilayer wiring block 11, is a block serving primarily as a passive functional part of the composite electronic component 10. As illustrated in (a) and (b) in Fig. 1, the chip-type electronic component built-in multilayer block 12 contains a first chip-type electronic component 12A and is formed as a laminated body having a plurality of laminated insulating layers 12B, inside of which a wiring pattern 12C is disposed, similarly to the multilayer wiring block 11.

The first chip-type electronic component 12A is formed of a ceramic sintered body such as a chip-type condenser, a chip-type inductor, and a chip-type resistor, for example. The insulating layers 12B are preferably formed primarily of a mixture of an inorganic filler and a thermosetting resin such as an epoxy resin. The insulating layers 12B may be formed of a material different from that from which the above-described insulating layers 11A are formed, such as a ceramic and a resin, or an epoxy resin containing an epoxy resin and an inorganic filler. As illustrated in (b) in the figure, the wiring pattern 12C is composed, for example, of a plurality of inner conducting planes 12D each provided between the individual insulating layers 12B, via hole conductors 12E each penetrating the individual insulating layers 12B and electrically connecting an upper and a lower inner conducting planes 12D, a first external terminal electrode 12F disposed on the bottom surface of the laminated body, and a second external terminal electrode 12G disposed on the top surface of the laminated body. The first chip-type electronic component 12A is implemented at an appropriate position on the inner conducting planes 12D. The chip-type electronic component built-in multilayer block 12 is connected to the surface wiring pattern 14A of the supporting substrate 14 through the first external terminal electrode 12F disposed on the bottom surface. An active element such as a silicon semiconductor may be implemented in the second external terminal electrode 12G on the top surface of the chip-type electronic component built-in multilayer block 12 as necessary.

The second chip-type electronic component 13 is constituted, for example, by a passive element made from a ceramic sintered body or an active element made from a silicon semiconductor, and is electrically connected to the surface wiring pattern 14A of the support body 14 through the external terminal electrode 13A provided on the bottom surface, as illustrated in (a) in Fig. 1. This second chip-type electronic component 13 is electrically interconnected through the supporting substrate 14 to and cooperates with the multilayer wiring block 11 and the chip-type electronic component built-in multilayer block 12, thus providing various functions in the composite electronic component 10.

The second chip-type electronic component 13 and the first chip-type electronic component 12A contained in the chip-type electronic component built-in multilayer block 12 are basically classified according to size. It is difficult to build a chip-type electronic component in a laminated body if the thickness, length, and width of the chip-type electronic component are greater than 0.8 mm, 1.6 mm, and 0.8 mm, respectively. Thus, such a chip-type electronic component is arranged along with the multilayer wiring block 11 or the like, as the second chip-type electronic component 13. Accordingly, a chip-type electronic component having a size smaller than the above size is built in the chip-type electronic component built-in multilayer block 12 and used as the first chip-type electronic component 12A.

The supporting substrate 14 may be, but not particularly limited to, a resin multilayer substrate or a ceramic multilayer substrate, for example, as long as it has a surface wiring pattern 14A.

As described above, according to the present example. the composite electronic component 10 provided with the multilayer wiring block 11, the chip-type electronic component built-in multilayer block 12, and the second chip-type electronic component 13, each having a different function can be obtained. These are electrically interconnected and arranged on the same plane, and thus the composite electronic component 10 can provide a plurality of functions to realize enhanced functions and promotes miniaturization and profile reduction of substrates.

Further, according to the present example, the insulating layers 11A of the multilayer wiring block 11 and the insulating layers 12B of the chip-type electronic component built-in multilayer block 12 can be configured by using different materials. For example, an organic material is used for one and an inorganic material is used for the other. Thus, even if the composite electronic component 10 is mounted on the supporting substrate 14 made of a different type of material, the residual stresses of the individual blocks 11 and 12 that constitute the composite electronic component 10 are different from each other. Each of the residual stresses can be relaxed on the supporting substrate 14, which can suppress negative effects of physical characteristics such as strain and thus increases reliability.

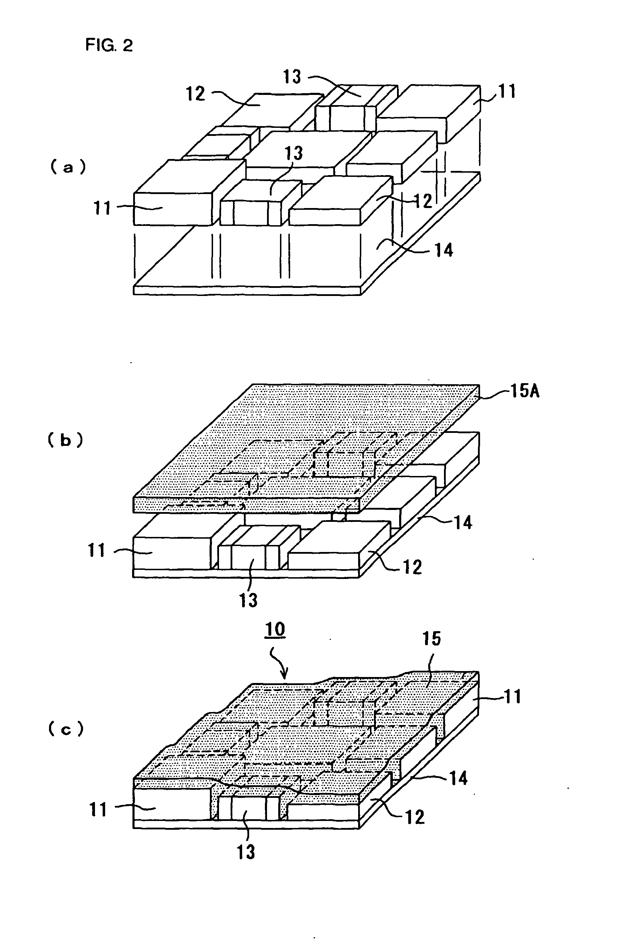

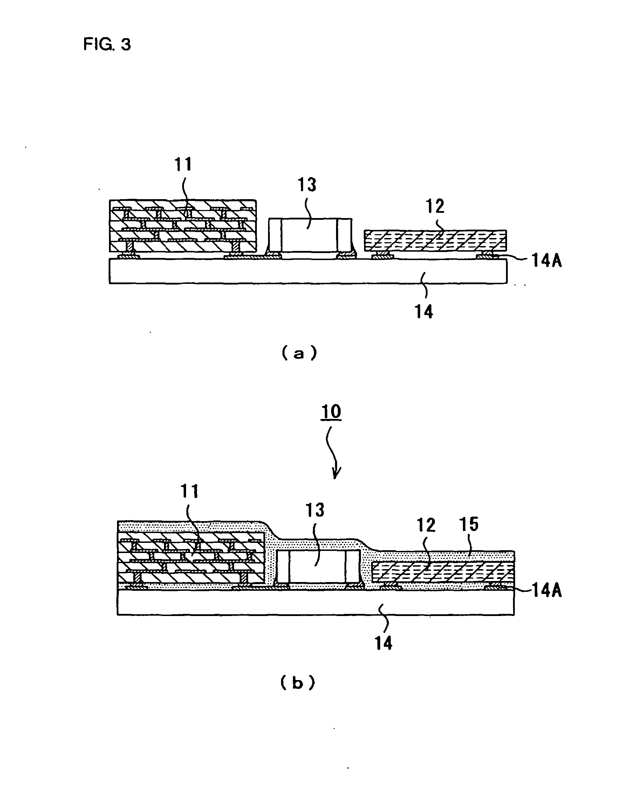

Next, referring to Fig. 2 and Fig. 3, an example of a method of manufacturing the composite electronic component 10 illustrated in Fig. 1 will be described. In manufacturing the composite electronic component 10, the multilayer wiring block 11, the chip-type electronic component built-in multilayer block 12, the second chip-type electronic component 13, and the supporting substrate 14, which have been manufactured in advance, are prepared. Then, as illustrated in (a) in Fig. 2, each of the multilayer wiring block 11, the chip-type electronic component built-in multilayer block 12, and the second chip-type electronic component 13 is aligned at a predetermined position on the surface wiring pattern 14A of the supporting substrate 14 and then implemented on the supporting substrate 14, as illustrated in (a) in Fig. 3.

Subsequently, as illustrated in (b) in Fig. 2, a resin prepreg sheet 15A in an uncured state (i.e., B-stage state) is arranged above the supporting substrate 14. The prepreg sheet 15A is then placed over the multilayer wiring block 11, the chip-type electronic component built-in multilayer block 12, and the second chip-type electronic component 13, and is then heat-press-bonded at a temperature higher than the curing temperature of the uncured resin portion. This causes the resin to flow, filling a space between each of the multilayer wiring block 11, chip-type electronic component built-in multilayer block 12, and the second chip-type electronic component 13 and to cover the top surfaces of these parts, as illustrated in (c) in Fig. 2. Then the uncured resin portion is heat-cured so that the multilayer wiring block 11, chip-type electronic component built-in multilayer block 12, and the second chip-type electronic component 13 are integrated through the resin portion 15. With this process, the composite electronic component 10 as illustrated in (b) Fig. 3 can be obtained.

Thus, according to the manufacturing method according to the present example, a substrate and an electronic component produced through different manufacturing processes, i.e., the multilayer wiring block 11, the chip-type electronic component built-in multilayer block 12, and the second chip-type electronic component 13, are appropriately combined, so that the composite electronic component 10 provided with various functions can be manufactured.

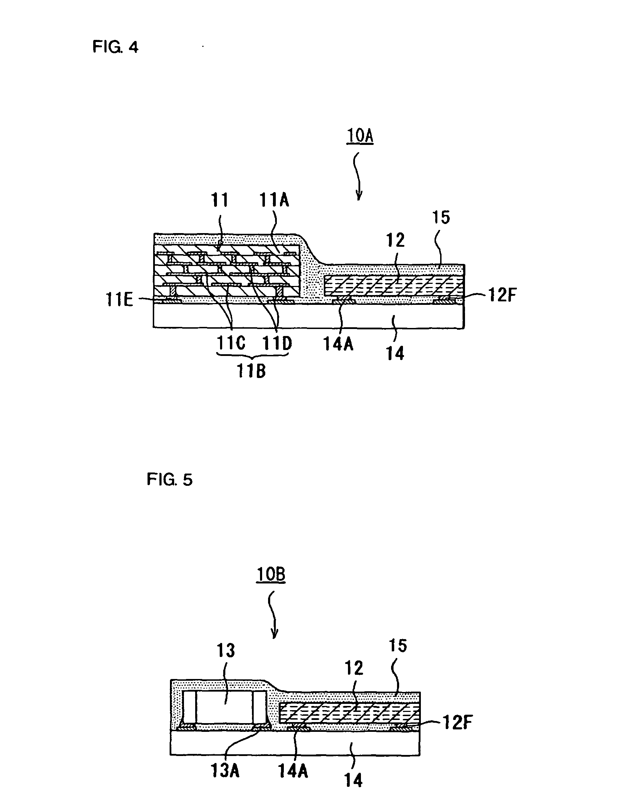

In the first example, the composite electronic component 10 is described, in which the multilayer wiring block 11, the chip-type electronic component built-in multilayer block 12, and the second chip-type electronic component 13 are implemented, and these three parts 11, 12, and 13 are electrically interconnected on the supporting substrate 14 through the surface wiring pattern 14A. However, in the composite electronic component , it may be possible that, as illustrated in Fig. 4 to Fig. 6, at least any two of the multilayer wiring block 11, the chip-type electronic component built-in multilayer block 12, and the second chip-type electronic component 13 are appropriately selected according to need, and the selected two parts are arranged on the same supporting substrate 14 and electrically interconnected. Modification examples will be described. In this description, the same reference numerals are used as those used in the present example are used to designate the same or equivalent parts.

As illustrated in Fig. 4, a composite electronic component 10A of a first modification example is configured according to the first example and has a multilayer wiring block 11, a chip-type electronic component built-in multilayer block 12, a supporting substrate 14 for supporting both the parts 11 and 12, and a resin portion 15 covering the multilayer wiring block 11 and the chip-type electronic component built-in multilayer block 12 on the supporting substrate 14. The multilayer wiring block 11 and the chip-type electronic component built-in multilayer block 12 are electrically connected through a surface wiring pattern 14A disposed on the surface of the supporting substrate 14. Thus, by disposing the multilayer wiring block 11, which shares the wiring separately from the wiring pattern 12C of the chip-type electronic component built-in multilayer block 12, to a side of the chip-type electronic component built-in multilayer block 12, the wiring pattern 12C of the chip-type electronic component built-in multilayer block 12 can be laterally expanded. With this arrangement, profile reduction of the composite electronic component 10A can be realized, similarly to the first embodiment.

As illustrated in Fig. 5, a composite electronic component 10B of a second modification example is configured in accordance with the first example, and has a chip-type electronic component built-in multilayer block 12, a second chip-type electronic component 13, a supporting substrate 14 for supporting both the parts 12 and 13, and a resin portion 15 covering the chip-type electronic component built-in multilayer block 12 and the second chip-type electronic component 13 on the supporting substrate 14. The chip-type electronic component built-in multilayer block 12 and the second chip-type electronic component 13 are electrically connected through a surface wiring pattern 14A disposed on a surface of the supporting substrate 14. For example, when the second chip-type electronic component 13 contains a coil component, the second chip-type electronic component 13 is disposed at a side of the chip-type electronic component built-in multilayer block 12. Thus, no wiring pattern is provided above or below the second chip-type electronic component 13 containing the coil component, and further, the second chip-type electronic component 13 is sealed with the resin portion 15. Therefore, a magnetic field based on the coil component is hardly affected by the wiring pattern 12C of the chip-type electronic component built-in multilayer block 12, and thus the reliability of the composite electronic component 10B can be increased. In addition, a chip-type electronic component having a coil component is provided not as the first chip-type electronic component 12A but as the second chip-type electronic component 13 disposed independently of a wiring pattern. Thus, a magnetic field based on the coil component can hardly be affected by the wiring pattern 12C of the chip-type electronic component built-in multilayer block 12. With this arrangement, the magnetic field based on the coil component is hardly affected by the wiring pattern 12C in the chip-type electronic component built-in multilayer block 12, and thus the reliability of the composite electronic component 10B can be increased, similarly to the first example.

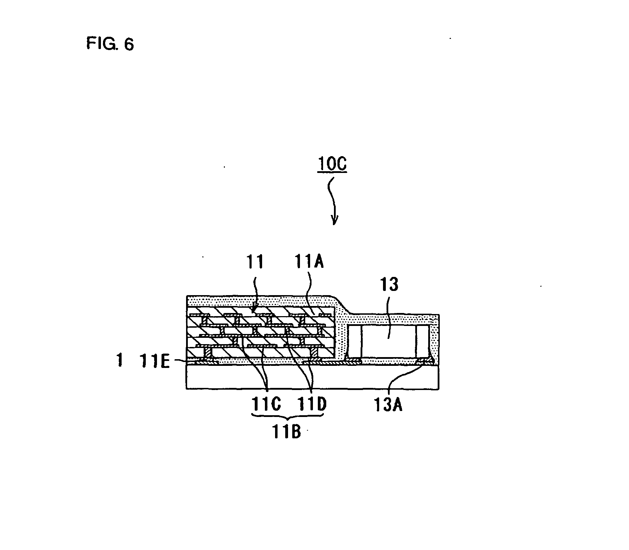

As illustrated in Fig. 6, a composite electronic component 10C of a third modification example is configured in accordance with the first example and has the multilayer wiring block 11, the second chip-type electronic component 13, the supporting substrate 14 for supporting both the parts 11 and 13, and the resin portion 15 covering the multilayer wiring block 11 and the second chip-type electronic component 13 on the supporting substrate 14. The multilayer wiring block 11 and the chip-type electronic component 13 are electrically connected through the surface wiring pattern 14A disposed on a surface of the supporting substrate 14. When the second chip-type electronic component 13 contains a coil component, the second chip-type electronic component 11 is disposed to a side of the second chip-type electronic component 13. Thus, no wiring pattern is provided above or below the second chip-type electronic component 13, and further, the second chip-type electronic component 13 is sealed with the resin portion 15. Therefore, a magnetic field based on the coil component is hardly affected by the wiring pattern 11B of the multilayer wiring block 11, and the reliability of the composite electronic component 10C can be increased, similarly to the first example.

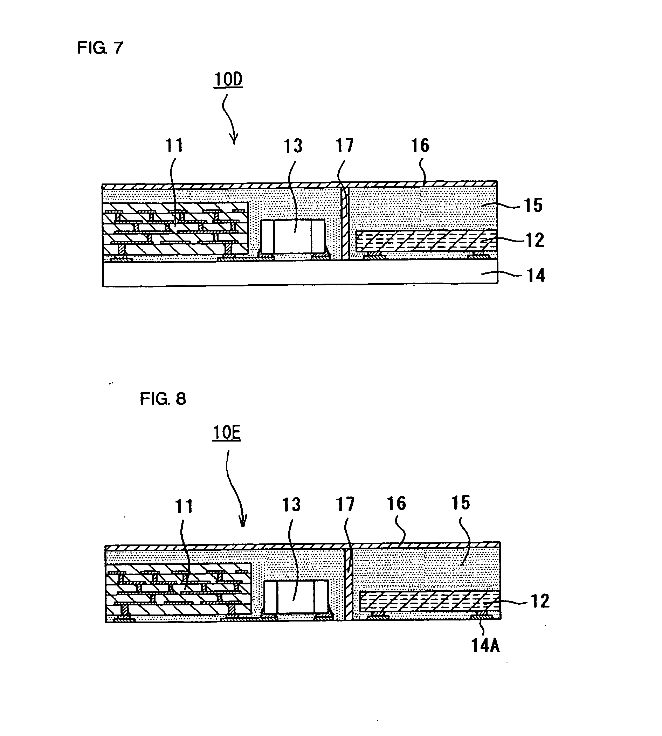

Now, referring to Fig. 7 to Fig. 14, other examples of a composite electronic component will be described. The same reference numerals as those in the above example are used to designate the same or equivalent parts.

Second example As illustrated in Fig. 7, a composite electronic component 10D of the present example is configured in accordance with the above-described example, except that it has a shield electrode and a via hole conductor. Specifically, the composite electronic component 10D of the present example has a multilayer wiring block 11, a chip-type electronic component built-in multilayer block 12, a second chip-type electronic component 13, and a supporting substrate 14, as illustrated in Fig. 7. The multilayer wiring block 11, the chip-type electronic component built-in multilayer block 12, and the second chip-type electronic component 13 are integrated on a supporting substrate 14 through the resin portion 15 formed of a prepreg sheet. The top surface of the resin portion 15 is planarized, and a shield electrode 16 is disposed on the planarized top surface. This shield electrode 16 and the supporting substrate 14 are electrically connected through a via hole conductor 17 having a cross-section in the shape of a circle, an oval, etc., for example.

Thus, the interior of the composite electronic component 10D can be protected from an external magnetic environment. In addition, the via hole conductor 17 is interpositioned between the chip-type electronic component built-in multilayer block 12 and the second chip-type electronic component 13. This arrangement suppresses electromagnetic interference between the chip-type electronic component built-in multilayer block 12 and the second chip-type electronic component 13, which are arranged side by side, and thus the space between each of the blocks 11 and 12 and second the chip-type electronic component 13 can be reduced. This permits high density implementation and, consequently, miniaturization of the composite electronic component 10D.

When the shield electrode 16 and the via hole conductor 17 are disposed, the top surface of a resin prepreg sheet having metal powder such as copper powder adhered thereto, which is heat-press-bonded similarly to the above-described embodiment, is planarized. Then, the metal powder on the top surface is etched into a predetermined pattern using a photo lithography technique and an etching technique. Subsequently, a via hole is formed by irradiating CO₂ laser light onto a predetermined area on the resin portion 15. After a desmear process is performed on each via hole, the via hole is filled with copper metals in the order of electroless copper plating and electrolytic copper plating, so that the via hole conductor 17 is formed, and the shield electrode 16 and the surface wiring pattern 14A of the supporting substrate 14 are electrically connected.

As described in the foregoing, according to the present example, the same operation effects as those in the first embodiment can be expected. In addition, the interior of the chip-type electronic component 10D can be protected from an external magnetic environment using the shield electrode 16, and electromagnetic interference between the chip-type electronic component built-in multilayer block 12 and the second chip-type electronic component 13, which are arranged side by side, is prevented. This allows a space between the parts 12 and 13 to be reduced so that the density can be increased.

### Third example

A composite electronic component 10E of the present example is configured similarly to the composite electronic component 10D illustrated in Fig. 7, except that it is devoid of the supporting substrate 14 of the composite electronic component 10D. As illustrated in Fig. 8, the composite electronic component 10E of the present example can be disposed, for example, on a detachable transfer sheet or a detachable transfer film (not shown). When the composite electronic component 10E is implemented on a mounting substrate such as a mother substrate, the transfer sheet or the transfer film is detached from the composite electronic component 10E and implemented on the mounting substrate. Specifically, a metal foil such as a copper foil, for example, is detachably attached to the transfer sheet. After the surface wiring pattern 14A is formed into a predetermined pattern using a photo lithography technique and an etching technique, the multilayer wiring block 11, the chip-type electronic component built-in multilayer block 12, and the second chip-type electronic component 13 are implemented in accordance with the surface wiring pattern 14A. Then, a resin prepreg sheet is press-bonded so that the multilayer wiring block 11, the chip-type electronic component built-in multilayer block 12, and the second chip-type electronic component 13 are integrated. Thus, the composite electronic component 10E can be obtained. Specifically, in the composite electronic component 10E, implementation on a mounting substrate such as a mother substrate is performed in accordance with the wiring pattern 14A directly connected to the external terminal electrode of each of the blocks.

According to the present example, the same operation effects as those in each of the above-described examples can be expected. In addition, by creating the composite electronic component 10E on the detachable transfer sheet or transfer film, the composite electronic component 10E can be mounted on a predetermined mounting substrate simply by detaching the transfer sheet of transfer film as necessary.

### First Embodiment

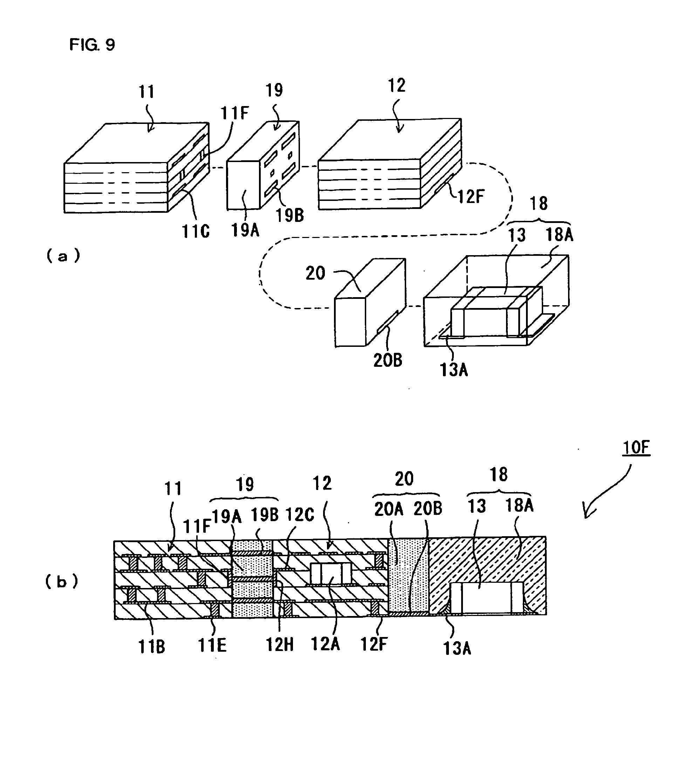

Also in the present embodiment, the embodiment will be described using the same reference numerals as those in each of the above examples to designate the same or equivalent parts.
As illustrated in (a) and (b) in Fig. 9, a composite electronic component 10F of the present embodiment has the multilayer wiring block 11, the chip-type electronic component built-in multilayer block 12, and the second chip-type electronic component 13. The insulating layers of each of these multilayer wiring block 11 and the chip-type electronic component built-in multilayer block 12 are formed of a thermosetting resin. The individual multilayer wiring block 11, chip-type electronic component built-in multilayer block 12, and the second chip-type electronic component 13 are provided with the external terminal electrodes 11E, 12F, and 13A, respectively, on the bottom surfaces. Each of the external terminal electrodes 11E, 12F, and 13A have configurations according to the external terminal electrode used in each of the above embodiments. In the present embodiment, the second chip-type electronic component 13 is sealed with a thermosetting resin 18A in advance and configured as a chip-type electronic component block 18 having the shape of a block. As illustrated in (b) in Fig. 9, in the composite electronic component 10F, the multilayer wiring block 11, the chip-type electronic component built-in multilayer block 12, and the chip-type electronic component block 18, each formed to have the same height, are electrically interconnected through a first resin block 19 and a second resin block 20 so as to be integrated. The first and second resin blocks 19 and 20 are also formed so as to have the same height as the height of the other blocks.

Then, as illustrated in (a) and (b) in Fig. 9, the first resin block 19 has a laminated body 19A having a plurality of laminated insulating layers (for example, resin prepreg sheets) and a connecting conductor 19B serving as an inner conducting plate formed on a predetermined insulating layer in the laminated body 19A so as to extend from one side to another side. The connecting conductor 19B appears on both sides of the laminated body so as to serve as an interface connecting the adjacent multilayer wiring block 11 and the chip-type electronic component built-in multilayer block 12. The connecting conductor 19B is formed as an inner conducting plane having a predetermined pattern. In addition, as illustrated in (b) in the same figure, for example, a side conducting plane 11F is disposed on connecting surfaces of the multilayer wiring block 11 and the first resin block 19 as necessary. Likewise, a side conducting plane 12H is disposed on connecting surfaces of the chip-type electronic component built-in multilayer block 12 and the first resin block 19 as necessary. Then, with these side conducting planes 11F and 12H, the multilayer wiring block 11 and the chip-type electronic component built-in multilayer block 12 are electrically connected through the first resin block 19 with certainty, even if there is a difference in level between each of the connecting conductor 19B of the first resin block 19 and the inner conducting plane 11C of the multilayer wiring block or the inner conducting plane 12D of the chip-type electronic component built-in multilayer block 12.

As illustrated in (a) and (b) in Fig. 9, the second resin block 20 is configured according to the first resin block 19, and its connecting conductor 20B appears on both sides of a laminated body 20A. This connecting conductor 20B is formed as the bottom surface of the laminated body 20A and connects the external terminal electrode 12F of the chip-type electronic component built-in multilayer block 12 and the external terminal electrode 13A of the second chip-type electronic component 13 in the chip-type electronic component block 18.

When the composite electronic component 10F of the present embodiment is created, firstly, the multilayer wiring block 11, the chip-type electronic component built-in multilayer block 12, the chip-type electronic component block 18, and the first and second resin blocks 19 and 20 are created. These blocks are formed so as to have substantially the same shape. The multilayer wiring block 11, the chip-type electronic component built-in multilayer block 12, and the chip-type electronic component block 18 are cured or fired blocks. However, the first and second resin blocks 19 and 20 are formed of an uncured thermosetting resin. Then, these blocks 11, 12, 18, 19, and 20 are aligned on a detachable sheet in the order illustrated in (a) in Fig. 9. Then, these aligned blocks are heated to a temperature at which the thermosetting resin of the first and second resin blocks 19 and 20 for connection are cured, under a state in which the surfaces of the longitudinally opposite ends and the top and bottom surfaces of the blocks are fixed.
At the same time, a predetermined pressure is applied from the remaining side surfaces of the blocks so that the blocks are heat-press-bonded so as to be integrated. Then the blocks are cooled, and thus the composite electronic component 10F can be obtained. When the composite electronic component 10F is implemented on a predetermined mounting substrate (not shown), the composite electronic component 10F is detached from the sheet and attached to the predetermined mounting substrate by soldering.

As describe in the foregoing, according to the present embodiment, the same operation effects as those in the above examples can be expected. In addition, by combining the multilayer wiring block 11, the chip-type electronic component built-in multilayer block 12, the chip-type electronic component block 18, and the first and second resin blocks 19 and 20, the composite electronic component 10F which meets various purposes can be obtained.

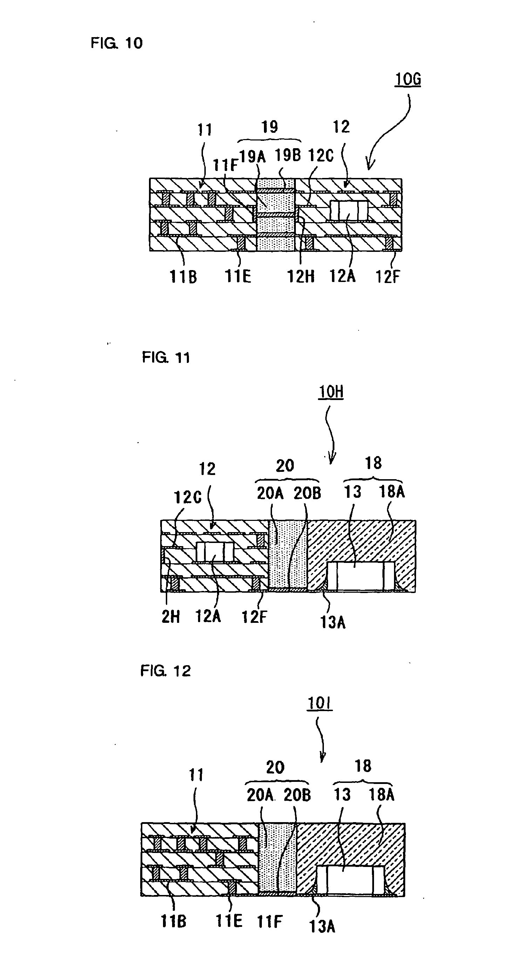

In the present embodiment, the composite electronic component 10F is illustrated, in which the multilayer wiring block 11, the chip-type electronic component built-in multilayer block 12, the chip-type electronic component block 18, each formed to have the same height, are electrically connected through the first and second resin blocks 19 and 20, so as to be integrated. However, as illustrated in Fig. 10 to Fig. 12, the composite electronic component of the present invention can be configured such that at least any two of the multilayer wiring block 11, the chip-type electronic component built-in multilayer block 12, and the chip-type electronic component block 18 are appropriately selected according to need, and the selected two parts are electrically connected through the first resin block 19 or the second resin block 20. An example of such a modification will be described using the same reference numerals as those in the present embodiment to refer to the same or equivalent parts.

As illustrated in Fig. 10, a composite electronic component 10G of a first modification example has the multilayer wiring block 11, the chip-type electronic component built-in multilayer block 12, and the first resin block 19 electrically connecting these parts 11 and 12. The other features are configured according to the composite electronic component 10F illustrated in Fig. 9. When the chip-type electronic component built-in multilayer block 12 contains a plurality of the first chip-type electronic components 12A, a part of or much of the wiring pattern 12C of the chip-type electronic component built-in multilayer block 12 can be shared by the multilayer wiring block 11. Thus, it is not necessary to extend the wiring pattern in the upper or lower direction. Accordingly, similarly to the first embodiment, a part of or many of the wiring pattern 12C of the chip-type electronic component built-in multilayer block 12 can be shared by the multilayer wiring block 11, and the wiring pattern 12C of the chip-type electronic component built-in multilayer block 12 needs not be extended in the upper or lower direction. This promotes reduction of the profile of the composite electronic component 10G.

As illustrated in Fig. 11, a composite electronic component 10H of a second modification has the chip-type electronic component built-in multilayer block 12, the chip-type electronic component block 18, and the second resin block 20 electrically connecting these parts 12 and 18. The other features of the composite electronic component 10H are configured according to the composite electronic component 10F illustrated in Fig. 9. When the composite electronic component contains a coil component, the chip-type electronic component containing the coil component is configured as the second chip-type electronic component 13 in the chip-type electronic component block 18. With this arrangement, the chip-type electronic component containing the coil component can be removed from the chip-type electronic component built-in multilayer block 12. Thus, the chip-type electronic component containing the coil component is made independent as the chip-type electronic component block 18, and thus no wiring pattern is disposed above and below the chip-type electronic component containing the coil component. Further, the chip-type electronic component containing the coil component is sealed with a resin portion 18A. Accordingly, a magnetic field based on the coil component is hardly affected by the wiring pattern 12C of the chip-type electronic component built-in multilayer block 12, similarly to the first embodiment, and thus the composite electronic component 10H with high reliability can be obtained.

As illustrated in Fig. 12, a composite electronic component 10I of a third modification example has the multilayer wiring block 11, the chip-type electronic component block 18, and the second resin block 20 electrically connecting these two parts 11 and 18. The other features of the composite electronic component 10I are configured according to the composite electronic component 10F illustrated in Fig. 9. When the second composite electronic component 13 in the chip-type electronic component block 18 contains a coil component, the wiring portion of the second chip-type electronic component 13 is made independent as the multilayer wiring block 11 and disposed to a side of the chip-type electronic component block 18 through the second resin block 20. Thus, no wiring pattern is disposed above and below the second chip-type electronic component 13 containing the coil component, and further, the second chip-type electronic component 13 is sealed with the resin portion 18A. Accordingly, the composite electronic component 10I, in which a magnetic field based on the coil component is hardly affected by the wiring pattern 11B of the multilayer wiring block 11, can be obtained, similarly to the fourth embodiment.

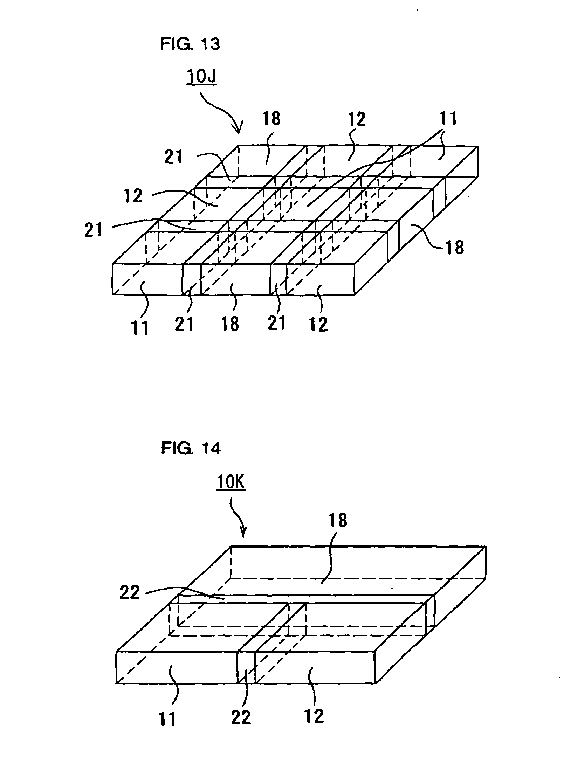

As illustrated in Fig. 13 and Fig. 14, a composite electronic component of the present invention can be configured such that an appropriate number of each of the multilayer wiring block 11, the chip-type electronic component built-in multilayer block 12, and the chip-type electronic component block 18 are selected or an appropriate number of the blocks each formed to have an appropriate shape are arranged, so as to be integrated, in accordance with the functions of the composite electronic component. In addition, the composite electronic component of the present invention can also be configured such that an appropriate number of only the same type of blocks are arranged so as to be integrated.

### Second Embodiment

As illustrated in Fig. 13, a composite electronic component 10J of the present embodiment has the multilayer wiring block 11, the chip-type electronic component built-in multilayer block 12, the chip-type electronic component block 18 each formed to have generally the same height, width, and length and a resin block 21 electrically and mechanically connecting adjacent blocks. These are arranged in accordance with the purposes and formed to have a rectangular shape as a whole.

According to the present embodiment, the same operation effects as those in the first embodiment can be expected. In addition, by appropriately combining each of the multilayer wiring block 11, the chip-type electronic component built-in multilayer block 12, the chip-type electronic component block 18, and the resin block 21, the composite electronic component 10J which meets various purposes can be obtained.

### Third Embodiment

As illustrated in Fig. 14, in a composite electronic component 10K of the present embodiment, any two of the multilayer wiring block 11, the chip-type electronic component built-in multilayer block 12, and the chip-type electronic component block 18 are formed to have the same size, and the other one is formed to have an area which is approximately double the area of each of the two blocks. These blocks 11, 12, and 18 form a rectangular shape as a whole and electrically and mechanically interconnected through a resin block 22.

According to the present embodiment, the same operation effects as those in the first embodiment can be expected. In addition, by appropriately combining each of the multilayer wiring block 11, the chip-type electronic component built-in multilayer block 12, the chip-type electronic component block 18, and the resin block 22, the composite electronic component 10K which meets various purposes can be obtained.

It should be noted that the present invention is by no means limited to the embodiments described above. For example, a plurality of each of multilayer wiring blocks, chip-type electronic component built-in multilayer blocks, and chip-type electronic components can be applied. In addition, the blocks can be formed of different materials or have different characteristics. In short,
any composite electronic component in which the multilayer wiring block, the chip-type electronic component built-in multilayer block, and the chip-type electronic component are press-bonded and electrically interconnected through a resin block as defined in claim 1, and its manufacturing method as defined in claim 4, are encompassed by the present invention. Further, a plurality of the multilayer wiring blocks, the chip-type electronic component built-in multilayer blocks, and the chip-type electronic components may be provided. In addition, the blocks may be formed of different materials, or may have different materials.

### Industrial Applicability

The present invention can preferably be applied, for example, to a composite electronic component used in a mobile communication device such as a portable phone and to a method of manufacturing the composite electronic component.

## Claims

1. A composite electronic component comprising a multilayer wiring block (11) having a plurality of laminated insulating layers and a wiring pattern, and a chip-type electronic component (12) built-in multilayer block having a plurality of laminated insulating layers and also containing a first chip-type electronic component (12A), wherein the multilayer wiring block (11) and the chip-type electronic component built-in multilayer block (12) are electrically interconnected, arranged on the same plane and integrated through a resin block (19) arranged between the multilayer wiring block (11) and the chip-type electronic component built-in multilayer block (12),
wherein the resin block (19) has a laminated body (19A)
and a connecting wiring (19B) arranged between two insulating layers of the laminated body (19A) for electrically interconnecting the multilayer wiring block (11) and the chip-type electronic component built-in multilayer block (12).

2. The composite electronic component according to claim 1, further comprising a second chip-type electronic component block, in which a chip-type electronic component (13) composed of a passive component or an active component is resin-sealed, wherein the multilayer wiring block (11), the chip-type electronic component built-in multilayer block (12), and the chip-type electronic component block (18) are integrated through resin blocks (19, 20).

3. The composite electronic component according to any one of claims 1 or 2, wherein the multilayer wiring block (11) and the chip-type electronic component built-in multilayer block (12) are formed of different materials.

4. A method of manufacturing a composite electronic component according to claim 1 comprising the steps of arranging at least any two of a multilayer wiring block (11) having a plurality of laminated insulating layers and a wiring pattern, a chip-type electronic component built-in multilayer block (12) having a plurality of laminated insulating layers and also containing a first chip-type electronic component (12A), and a chip-type electronic component block (18) in which a second chip-type electronic component (13) is resin-sealed, and a resin block (19, 29) having a wiring pattern (19A, 19B, 20B), and press-bonding and electrically interconnecting at least any two of the multilayer wiring block (11), the chip-type electronic component built-in multilayer block (12),
and the second chip-type electronic component (13), through the resin block (19, 20).

5. The method of manufacturing a composite electronic component according to claim 4, wherein the step of arranging includes arranging each of the multilayer wiring block (11), the chip-type electronic component built-in multilayer block (12), the chip-type electronic component block (18), and resin blocks (19, 20), and the step of press-bonding and electrically interconnecting comprises press-bonding and electrically interconnecting the multilayer wiring block (11), the chip-type electronic component built-in multilayer block (12), and the second chip-type electronic component (13), through the resin blocks.

## Patentansprüche

1. Eine zusammengesetzte Elektronikkomponente, die einen Mehrschicht-Verdrahtungsblock (11), der eine Mehrzahl laminierter isolierender Schichten und eine Verdrahtungsstruktur aufweist, und einen Mehrschichtblock mit eingebauter Chiptyp-Elektronikkomponente (12), der eine Mehrzahl laminierter isolierender Schichten aufweist und ferner eine erste Chiptyp-Elektronikkomponente (12A) enthält, aufweist, wobei der Mehrschicht-Verdrahtungsblock (11) und der Mehrschichtblock (12) mit eingebauter Chiptyp-Elektronikkomponente elektrisch miteinander verbunden, auf derselben Ebene angeordnet und durch einen Harzblock (19) integriert sind, der zwischen dem Mehrschicht-Verdrahtungsblock (11) und dem Mehrschichtblock (12) mit eingebauter Chiptyp-Elektronikkomponente angeordnet ist,
wobei der Harzblock (19) einen laminierten Körper (19A) und eine Verbindungsverdrahtung (19B) aufweist, die zwischen zwei isolierenden Schichten des laminierten Körpers (19A) angeordnet ist, um den Mehrschicht-Verdrahtungsblock (11) und den Mehrschichtblock (12) mit eingebauter Chiptyp-Elektronikkomponente elektrisch miteinander zu verbinden.

2. Die zusammengesetzte Elektronikkomponente gemäß Anspruch 1, die ferner einen Zweite-Chiptyp-Elektronikkomponente-Block aufweist, bei dem eine Chiptyp-Elektronikkomponente (13), die aus einer passiven Komponente oder einer aktiven Komponente gebildet ist, mit Harz abgedichtet ist, wobei der Mehrschicht-Verdrahtungsblock (11), der Mehrschichtblock (12) mit eingebauter Chiptyp-Elektronikkomponente und der Chiptyp-Elektronikkomponente-Block (18) durch Harzblöcke (19, 20) integriert sind.

3. Die zusammengesetzte Elektronikkomponente gemäß einem der Ansprüche 1 oder 2, bei der der Mehrschicht-Verdrahtungsblock (11) und der Mehrschichtblock (12) mit eingebauter Chiptyp-Elektronikkomponente aus verschiedenen Materialien gebildet sind.

4. Ein Verfahren zum Herstellen einer zusammengesetzten Elektronikkomponente gemäß Anspruch 1, das die Schritte eines Anordnens zumindest zweier beliebiger eines Mehrschicht-Verdrahtungsblockes (11), der eine Mehrzahl laminierter isolierender Schichten und eine Verdrahtungsstruktur aufweist, eines Mehrschichtblocks mit eingebauter Chiptyp-Elektronikkomponente (12), der eine Mehrzahl laminierter isolierender Schichten aufweist und ferner eine erste Chiptyp-Elektronikkomponente (12A) enthält, und eines Chiptyp-Elektronikkomponente-Blocks (18), bei dem eine zweite Chiptyp-Elektronikkomponente (13) mit Harz abgedichtet ist, und eines Harzblockes (19, 29), der eine Verdrahtungsstruktur (19A, 19B, 20B) aufweist, und eines Verbindens mittels Drucks und eines elektrischen Miteinanderverbindens zumindest beliebiger zwei des Mehrschicht-Verdrahtungsblockes (11), des Mehrschichtblocks (12) mit eingebauter Chiptyp-Elektronikkomponente und der zweiten Chiptyp-Elektronikkomponente (13) durch den Harzblock (19, 20) aufweist.

5. Das Verfahren zum Herstellen einer zusammengesetzten Elektronikkomponente gemäß Anspruch 4, bei dem der Schritt des Anordnens ein Anordnen jedes des Mehrschicht-Verdrahtungsblocks (11), des Mehrschichtblocks (12) mit eingebauter Chiptyp-Elektronikkomponente, des Chiptyp-Elektronikkomponente-Blocks (18) und von Harzblöcken (19, 20) umfasst, und der Schritt des Verbindens mittels Drucks und des elektrischen Miteinanderverbindens ein Verbindens mittels Drucks und ein elektrisches Miteinanderverbinden des Mehrschicht-Verdrahtungsblocks (11), des Mehrschichtblocks (12) mit eingebauter Chiptyp-Elektronikkomponente und der zweiten Chiptyp-Elektronikkomponente (13) durch die Harzblöcke aufweist.

## Revendications

1. Composant électronique composite comprenant un bloc de câblage multicouche (11) comportant une pluralité de couches isolantes stratifiées et un motif de câblage, et un bloc multicouche intégré de composants électroniques de type puce (12) comportant une pluralité de couches isolantes stratifiées et contenant également un premier composant électronique de type puce (12A), dans lequel le bloc de câblage multicouche (11) et le bloc multicouche intégré de composants électroniques de type puce (12) sont électriquement interconnectés, situés sur le même plan et intégrés au sein d'un bloc de résine (19) situé entre le bloc de câblage multicouche (11) et le bloc multicouche intégré de composants électroniques de type puce (12),
dans lequel le bloc de résine (19) comporte un corps stratifié (19A) et un câblage de connexion (19B) situé entre deux couches isolantes du corps stratifié (19A) pour interconnecter électriquement le bloc de câblage multicouche (11) et le bloc multicouche intégré de composants électroniques de type puce (12).

2. Composant électronique composite selon la revendication 1, comprenant en outre un second bloc de composants électroniques de type puce, dans lequel un composant électronique de type puce (13) composé d'un composant passif ou d'un composant actif est scellé par de la résine, dans lequel le bloc de câblage multicouche (11), le bloc multicouche intégré de composants électroniques de type puce (12), et le bloc de composants électroniques de type puce (18) sont intégrés au sein de blocs de résine (19,20).

3. Composant électronique composite selon l'une quelconque des revendications 1 ou 2, dans lequel le bloc de câblage multicouche (11) et le bloc multicouche intégré de composants électroniques de type puce (12) sont constitués de matériaux différents.

4. Procédé de fabrication d'un composant électronique composite selon la revendication 1, comprenant les étapes consistant à disposer au moins deux quelconques d'un bloc de câblage multicouche (11) comportant une pluralité de couches isolantes stratifiées et un motif de câblage, d'un bloc multicouche intégré de composants électroniques de type puce (12) comportant une pluralité de couches isolantes stratifiées et contenant également un premier composant électronique de type puce (12A), et d'un bloc de composants électroniques de type puce (18) dans lequel un second composant électronique de type puce (13) est scellé par de la résine, et d'un bloc de résine (19, 29) comportant un motif de câblage (19A, 19B, 20B), et à coller sous pression et à interconnecter électriquement au moins deux quelconques du bloc de câblage multicouche (11), du bloc multicouche intégré de composants électroniques de type puce (12), et du second composant électronique de type puce (13), au sein du bloc de résine (19,20).

5. Procédé de fabrication d'un composant électronique composite selon la revendication 4, dans lequel l'étape de disposition comprend la disposition de chacun du bloc de câblage multicouche (11), du bloc multicouche intégré de composants électroniques de type puce (12), du bloc de composants électroniques de type puce (18), et des blocs de résine (19, 20), et l'étape de collage sous pression et d'interconnexion électrique comprend le collage sous pression et d'interconnexion électrique du bloc de câblage multicouche (11), du bloc multicouche intégré de composants électroniques de type puce (12), et du second composant électronique de type puce (13), au sein des blocs de résine.
